# EUROPÄISCHE PATENTSCHRIFT

(11) **EP 0 513 080 B1**
(45) Veröffentlichungstag und Bekanntmachung des Hinweises auf die Patenterteilung: **20.07.1994**
(21) Anmeldenummer: 91903029.6
(22) Anmeldetag: 31.01.1991
(51) Int. Cl.: A01C 1/00

(54) **VERFAHREN UND EINRICHTUNG ZUR BEHANDLUNG VOM TEILCHENFÖRMIGEM MATERIAL MIT ELEKTRONENSTRALEN**
PROCESS AND DEVICE FOR ELECTRON BEAM TREATMENT OF PARTICULATES
PROCEDE ET DISPOSITIF DE TRAITEMENT DE MATERIAUX PARTICULAIRES PAR DES FAISCEAUX ELECTRONIQUES

(30) Priorität: 31.01.1990 DD 1; 31.01.1990 DD 1
(43) Veröffentlichungstag der Anmeldung: 19.11.1992
(73) Patentinhaber: PFITZNER, Christian (als Gesellschafter der Gesellschaft für Umweltschutzberatung und -technik GbR), 06502 Thale (DE); HEINZMANN, Rainer (als Gesellschafter der Gesellschaft für Umweltschutzberatung und -technik GbR), D-06484 Quedlinburg (DE); FRAUNHOFER-GESELLSCHAFT ZUR FÖRDERUNG DER ANGEWANDTEN FORSCHUNG E.V., 80636 München (DE); VON ARDENNE ANLAGENTECHNIK GMBH, 01324 Dresden (DE)
(72) Erfinder: GABER, Klaus, 01324 Dresden (DE); PANZER, Siegfried, 01279 Dresden (DE); SCHMIDT, Jörg, 01277 Dresden (DE); SCHILLER, Siegfried, 01326 Dresden (DE); KÜHN, Gerhard, 01324 Dresden (DE); SCHOLZE, Friederun, 06484 Quedlinburg (DE); ELLERT, Harald, 39218 Schönebeck/Elbe (DE); LINDNER, Kerstin, 14478 Potsdam (DE); SCHOLZE, Thomas, 01097 Dresden (DE); PFLAUMBAUM, Joachim, 38889 Blankenburg (DE); BURTH, Ulrich, 14532 Kleinmachnow (DE); GREILICH, Jörg, 39128 Magdeburg (DE)
(74) Vertreter: Grünecker, Kinkeldey, Stockmair & Schwanhäusser Anwaltssozietät
(86) Internationale Anmeldenummer: EP9100182
(87) Internationale Veröffentlichungsnummer: WO9111096

(56) Entgegenhaltungen:
- FR-A- 961 079
- FR-A- 2 025 147
- US-A- 4 633 611

## Beschreibung

Die vorliegende Erfindung betrifft ein Verfahren zur Behandlung von Schüttgut aus teilchenförmigem Material, insbesondere Saatgut, mit Elektronenstrahlen in einem Bestrahlungsfeld einer Bestrahlungskammer, durch die das Schüttgut hindurch bewegt, einer Elektronenstrahlbehandlung mit mehreren Elektronenstrahlen unterzogen und anschließend aus der Bestrahlungskammer abgeführt wird, sowie eine Einrichtung für eine solchen Behandlung. Die Erfindung betrifft insbesondere ein Verfahren zur Behandlung von körnigem, feuchten und mit Staub behafteten teilchenförmigen Material bzw. Schüttgut mit Elektronenstrahlen in Vakuum. Vorzugsweise dienen das Verfahren und die Einrichtung der Behandlung von Saatgut, insbesondere Getreide, welches einer Beizung mit Elektronenstrahlen unterzogen wird, um an den Samenkörnern anhaftende Krankheitserreger unwirksam zu machen.

Es ist bekannt, Saatgut allseitig mit niederenergetischen Elektronen zu bestrahlen. Die Elektronenenergie und Strahlendosis wird so bemessen, daß die Oberfläche und oberflächennahe Schicht ohne wesentliche Beeinträchtigung des Keimes beaufschlagt wird (DD-A 242 337). Dazu ist eine Einrichtung bekannt, die das Saatgut mittels Bewegungseinrichtungen in einem Rezipienten ständig umverteilt, wobei es dabei von einem abgelenkten und aufgefächerten Elektronenstrahl beaufschlagt wird. Mit dem Rezipienten sind Transporteinrichtungen zur Zu- und Abfuhr des Saatgutes mit den zugehörigen Schleusen verbunden (US-A 4 633 611).

Da besonders bei Saatgut an bzw. in der Oberfläche relativ viel Wasser gebunden ist, ist die Abdampfrate des Wassers bei dem erforderlichen Vakuum in der Bestrahlungskammer sehr hoch. Diesem Umstand ist nur mit einem hohen Evakuierungsaufwand zu begegnen. Dieses Verfahren und die Einrichtung hat außerdem den Nachteil, daß eine industrielle Anwendung, die einen hohen Durchsatz erfordert, infolge des hohen Staubanteils des Saatgutes nicht möglich ist. Diese hohe Staubentwicklung in der Bestrahlungskammer stört den Langzeitbetrieb der Elektronenkanone.

Es sind auch Bestrahlungseinrichtungen bekannt, mit denen das Schüttgut in freier Atmosphäre geführt wird (US-A-860 513 und 2 333 842). Diese Einrichtungen sind nicht geeignet, um die Beaufschlagung der Oberfläche und der oberflächennahen Schicht des Schüttgutes in genau vorgeschriebener Tiefe zu bewirken, insbesondere können aufgrund der auftretenden Energiedispersion phytotoxische Wirkungen für das Saatgut eintreten.

Aus der FR-A-961 079 ist eine Bestrahlungseinrichtung mit gegenüberliegend an einer Bestrahlungskammer angeordneten Elektronenstrahlerzeugern bekannt, bei der das zu bestrahlende Material von oben in die Bestrahlungskammer ein- und nach unten wieder aus dieser austritt. Eine solche Einrichtung schafft jedoch keine Voraussetzungen für eine hinreichend individuelle Bestrahlung von körnigem Schüttgutmaterial, wie Saatgut, zum Beizen dieses Materiales.

Bei der Ausführung der Verfahren mit den bekannten elektronenstrahltechnologischen Einrichtungen und den bekannten Schüttgutfördereinrichtungen hat sich gezeigt, daß relativ konstante Oberflächendosen nur bei kleinem Schüttgutdurchsatz erzielbar sind. Dagegen scheiterten alle Versuche, die verfahrensnotwendige Gleichmäßigkeit der Oberflächendosis bei gleichzeitig hohem Ausnutzungsgrad des Elektronenstrahls und hohem Massendurchsatz durch die Einrichtung zu erreichen, bzw. ergeben sich bei anderen Förderprinzipien, die diese Gleichmäßigkeit ermöglichten, technisch nicht mehr lösbare Evakuierungsprobleme. Die Lösung beider genannter Probleme ist aber eine unabdingbare Forderung bei einer industriellen Nutzung des Verfahrens.

Der Erfindung liegt daher die Aufgabe zugrunde, ein Verfahren der eingangs genannten Art derart zu verbessern, daß das Schüttgut aus teilchenförmigem Material mit Elektronen so bestrahlt wird, daß ein hoher Durchsatz bei geringen Verweilzeiten im Rezipienten möglich ist. Das Verfahren soll insbesondere auch für Schüttgut aus teilchenförmigem Material, wie z.B. Saatgut, mit verhältnismäßig hohem Wasser- und/oder Staubgehalt geeignet sein.

Der Erfindung liegt ferner die Aufgabe zugrunde, eine Einrichtung zur Behandlung von Schüttgut aus teilchenförmigem Material, insbesondere Getreide-Saatgut, mit Elektronenstrahlen anzugeben, die bei möglichst geringem apparativen Aufwand eine möglichst gleichmäßige und allseitige Bestrahlung des teilchenförmigen Materials durch Elektronenstrahlen ermöglicht und auch die Behandlung von Materialien ermöglicht, die einen verhältnismäßig hohen Wasser- und/oder Staubgehalt aufweisen.

Die vorgenannte Aufgabe wird in bezug auf das Verfahren erfindungsgemäß dadurch gelöst, daß das Schüttgut dosiert und unter Vereinzelung an einer Eintrittsseite der evakuierten Bestrahlungskammer zur Bildung eines kontinuierlichen Materialstromes aus vereinzeltem, teilchenförmigen Material im freien Fall durch die evakuierte Bestrahlungskammer geführt, die Elektronenstrahlen in Fallrichtung des Materiales aufgefächert werden und in dem Bestrahlungsfeld eine im wesentlichen allseitige Bestrahlung des vereinzelten, teilchenförmigen Materiales durch die aufgefächerten Elektronenstrahlen mehrseitig aus unterschiedlichen Richtungen erfolgt.

Aus dem teilchenförmigen Material wird somit ein Materialstrom gebildet und dieser durch die evakuierte Bestrahlungskammer bewegt, in der unter Vergrößerung des Teilchenabstandes innerhalb des Materialstromes dieser im freien Fall durch zumindest ein Bestrahlungsfeld der Bestrahlungskammer geführt, in dem Bestrahlungsfeld einer Elektronenstrahlbehandlung unterzogen und anschließend aus der Bestrahlungskammer abgeführt wird.

Vorzugsweise wird das teilchenförmige Material über zumindest eine Druckstufe der Bestrahlungskammer zugeführt und über zumindest eine weitere Druckstufe aus der Bestrahlungskammer abgeführt.

Hierbei wird bevorzugt, daß das teilchenförmige Material oder Schüttgut vor seiner Einführung und nach dem Austragen aus der Bestrahlungskammer, vorzugsweise vor bzw. nach einer jeweiligen Druckstufe für das Ein- und Ausschleusen des Schüttgutes, gegebenenfalls auch in der Bestrahlungskammer selbst, so zu steuern, daß eine Säule aus teilchenförmigem Material bzw. Schüttgut gebildet wird, die gegenüber ihrem Durchmesser eine große Höhe bzw. Axialerstreckung besitzt und als Strömungswiderstand wirkt.

Um das im Hinblick auf den Evakuierungsgrad im Rezipienten und eine lange, störungsfreie Arbeitsweise der zur Elektronenbehandlung verwendeten Elektronenstrahlerzeuger kritische Freisetzen von Entgasungsprodukten bzw. von Feuchte und/oder Staub aus dem teilchenförmigen Material bzw. Schüttgut möglichst gering zu halten, wird bevorzugt, daß das teilchenförmige Material bzw. Schüttgut in stufenweisem Druckübergang vom Atmosphärendruck auf den Innendruck in einer evakuierten Bestrahlungskammer (Rezipient) derart gefördert wird, daß dabei in jeder Druckstufe durch Evakuierung möglichst wenig Gase (Wasserdampf) und Staub abgesaugt werden. In den Druckstufen wird daher der Innendruck vorzugsweise so eingestellt, daß der Dampfdruck des Wassers nicht unterschritten wird.

Um eine gleichmäßige Bestrahlung der Teilchen des Materialstromes bzw. Schüttgutstromes zu erreichen, wird dafür Sorge getragen, daß die Teilchen das Bestrahlungsfeld mit zumindest annähernd gleicher Teilchengeschwindigkeit passieren.

Um eine möglichst gleichmäßige Dosisverteilung auf der Oberfläche des bestrahlten Teilchenmateriales, z.B. von Samenkörnern zu erreichen, wird das Material in dem Bestrahlungsfeld der Bestrahlungskammer Elektronenstrahlen ausgesetzt, die sehr breit aufgefächert sind und entlang eines Weges beaufschlagt, der oberhalb der Austrittsstelle des Elektronenstrahles aus einem Elektronenstrahlerzeuger beginnt und unterhalb desselben endet. Das heißt, vorzugsweise wird jedes Teilchen, z.B. Samenkorn, während des freien Falls in der Bestrahlungskammer im Bestrahlungsfeld einer Elektronenbestrahlung unterzogen, die von schräg nach oben bis schräg nach unten in bezug auf den Elektronenstrahlerzeuger gerichtet ist. Dadurch wird jedes Teilchen während des freien Falls verhältnismäßig lange und zumindest näherungsweise von allen Seiten beaufschlagt.

Es wird bevorzugt, daß das Stromdichteprofil des Bestrahlungsfeldes in vertikaler Richtung, d.h. in Fallrichtung des teilchenförmigen Materiales bzw. des Schüttgutstromes so ausgebildet ist, daß die Oberflächendosis des Materiales, z.B. von Saatgutkörnern, im wesentlichen gleichmäßig verteilt ist. Dabei kann ein Stromdichteprofil für jeden Elektronenstrahlerzeuger verwendet werden, das zwei über die ganze Breite des Materialstromes hinreichend gleichmäßig beuafschlagte Bereiche hoher Stromdichte besitzt, die durch einen Bereich niedriger Stromdichte oder gänzlich ausgesparter Beaufschlagung erzeugt werden, wobei das Stromdichteprofil der verwendeten Elektronenstrahlen dahingehend optimiert wird, daß die dieses Bestrahlungsfeld passierenden Teilchen, z.B. Saatgutkörner, über ihre Oberfläche eine hinreichend homogene Dosisverteilung erhalten.

Als weitere Maßnahme zur Homogenisierung der Oberflächendosis auf dem bestrahlten teilchenförmigen Material wird in der Bestrahlungskammer ein Evakuierungs- bzw. Arbeitsdruck im Bereich von ca. 10 Pa bis einige 100 Pa, vorzugsweise von ca. 100 Pa bis einige 100 Pa eingestellt, wodurch eine Winkelstreuung der beschleunigten Elektronen ohne störende Energieverluste erreicht wird.

Die Zeilenfrequenz des Elektronenstrahles liegt vorzugsweise bei einigen kHz und die Bildfrequenz im Bereich einiger 10 kHz bis einiger 100 kHz. Durch diese Programmierbarkeit der Ablenkfunktion können in vorteilhafter Weise Elektronenstrahlleistungsverluste infolge eines längeren Strahlweges bis zur Ebene des Materialstromes des teilchenförmigen Materiales bzw. Schüttgutstromes, Ausblendungen und andere Einflüsse kompensiert werden.

Eine besonders bevorzugte Ausführungsform des Verfahrens zur Behandlung von Schüttgut mit Elektronenstrahlen, insbesondere zur Behandlung von Saatgut gegen Schaderreger, zeichnet sich dadurch aus, daß das Schüttgut in eine evakuierte Bestrahlungskammer über Druckstufen ein- und ausgeschleust wird, wobei in jeder Druckstufe für das Einschleusen des Schüttgutes ein Mindestdruck herrscht, der zumindest dem Dampfdruck einer Flüssigkeit, insbesondere Wasser, in den oberflächennahen Schichten und an der Oberfläche des Schüttgutes entspricht und wobei eine Absaugung von Gasen, insbesondere Wasserdampf und Staub minimiert wird, und daß nach dem Passieren der Druckstufen das Schüttgut im freien Fall mit annähernd gleicher Einzelgeschwindigkeit der Teilchen des Schüttgutes bei einer Vereinzelung mit einer Transparenz im Bestrahlungsbereich von ca. 50% und einem mittleren Teilchenabstand in Richtung quer zur Strömungsrichtung des Schüttgutes, der größer ist als die Teilchengröße, sich durch die Bestrahlungskammer bewegt und dabei von mehreren aufgefächerten Elektronenstrahlen mehrseitig von Schräg nach oben nach schräg nach unten in bezug auf die Elektronenstrahlerzeugung beaufschlagt wird, wobei die Elektronenstrahlerzeugung mit zwei Elektronenkanonen in radial gegenüberliegender Anordnung in bezug auf den Schüttgutstrom erfolgt.

Als besonders vorteilhaft hat sich gemäß einer weiteren Ausführungsform der vorliegenden Erfindung die Kombination der nachfolgenden Verfahrensschritte für die Elektronenstrahlbehandlung des teilchenförmigen Materiales bzw. Schüttgutes, insbesondere für die Schaderregerbekämpfung an Getreidekörnern erwiesen. Das Schüttgut wird im stufenweisen Druckübergang von Atmosphärendruck auf den Evakuierungsdruck bzw. Arbeitsdruck in der Bestrahlungskammer derart gefördert, daß dabei in jeder Druckstufe durch Evakuierung möglichst wenig Gase (Wasserdampf) und Staub abgesaugt werden. Dazu wird der Druck in den Druckstufen so eingestellt, daß der Dampfdruck des Wassers nicht unterschritten wird. Der Druck in der Bestrahlungskammer wird vorzugsweise in einem Bereich zwischen 100 Pa und einigen 100 Pa gehalten. Nach Passieren der Druckstufen bewegt sich das Schüttgut im freien Fall mit annähernd gleicher Einzelgeschwindigkeit der Teilchen des Schüttgutstromes, z.B. Saatgut- bzw. Getreidekörner, durch die Bestrahlungskammer und wird dabei von mehreren aufgefächerten Elektronenstrahlen beaufschlagt. Die Vereinzelung der Teilchen im Material- bzw. Schüttgutstrom erfolgt dabei derart, daß die Transparenz im Bestrahlungsbereich ca. 50% beträgt und der mittlere Abstand der Teilchen in einer Querschnittsebene der Bestrahlungskammer größer ist als ihre Größe (Außenabmessung). In diesem Bereich wirken die Elektronenstrahlen von Elektronenkanonen mindestens zweiseitig und vorzugsweise annähernd zeitgleich auf die Teilchen ein. Die Elektronenstrahlen werden sehr breit aufgefächert und wirken dadurch mehrseitig entlang des Strömungsweges der Teilchen auf diese, und zwar in bezug auf die Elektronenstrahlerzeuger von schräg oben nach schräg unten. Dadurch wird jedes Teilchen im freien Fall von einem Punkt schräg oberhalb der Elektronenquelle bis nach schräg unterhalb derselben bestrahlt und wird unter Berücksichtigung der zweidimensionalen Auffächerung der Elektronenstrahlen näherungsweise von vier Seiten beaufschlagt. Unter Berücksichtigung auch der Eigenbewegung des Teilchens, z.B. Getreidekornes beim Fall durch den Bestrahlungsbereich wird auf diese Weise eine allseitige Beaufschlagung der Oberfläche der Teilchen mit Elektronenstrahlen und eine weitgehend homogene Verteilung der Oberflächendosis erreicht.

Das Evakuierungsregime des Elektronenstrahlerzeugers (Elektronenkanone) und der Bestrahlungskammer wird so geführt, daß die Luftströmungen beim Anpumpen und Belüften der Bestrahlungskammer und des mit dieser verbundenen Elektronenstrahlerzeugers stets von der Elektronenkanone zur Bestrahlungskammer gerichtet sind bzw. stets von dem Elektronenstrahlerzeuger und der Bestrahlungskammer nach der Atmosphärendruckseite hin gerichtet werden.

Der schnelle Übergang des teilchenförmigen Materiales bzw. Schüttgutes aus der eingangsseitig der Bestrahlungskammer angeordneten Druckstufenschleuse, in der ein Druck oberhalb des in der Oberfläche des zu behandelnden Materiales, z.B. Getreidekörner, gebundenen Wassers herrscht, in die Bestrahlungskammer mit einem wesentlich niedrigeren Arbeitsdruck und die kurze Verweilzeit in der Bestrahlungskammer bewirken eine schlagartige Temperaturabsenkdung auf der Oberfläche des teilchenförmigen Materiales bzw. Schüttgutes und damit eine Verringerung der Verdampfungsrate des Wassers.

Die vorgenannte Aufgabe wird im Hinblick auf die Einrichtung zur Behandlung von Schüttgut aus teilchenförmigem Material, insbesondere Saatgut mit Elektronenstrahlen in einer vertikal angeordneten Bestrahlungskammer, die eine obere Eintrittsöffnung und eine untere Austrittsöffnung für das Schüttgut aufweist und an der radial mehrere Elektronenstrahlerzeuger angeordnet sind, erfindungsgemäß dadurch gelöst, daß die Bestrahlungskammer evakuiert und an ihrem oberen Ende mit einer Verteilereinrichtung zur Vereinzelung des teilchenförmigen Materiales versehen ist, und die Elektronenstrahlerzeuger mit Ablenkeinrichtungen zum Auffächern der Elektronenstrahlen versehen sind, zur Bildung eines Bestrahlungsfeldes, durch das das aus der Verteilereinrichtung austretende teilchenförmige Material im freien Fall geführt ist.

Somit ist die evakuierte Bestrahlungskammer zur Aufnahme eines Materialstromes aus dem teilchenförmigen Material im freien Fall unter Vergrößerung des Teilchenabstandes in zumindest einem Bestrahlungsfeld der Bestrahlungskammer vorgesehen und die Elektronenstrahlerzeuger in radialer Anordnung relativ zu dem Materialstrom im Bereich des Bestrahlungsfeldes angeordnet sowie mit Ablenkeinrichtungen zum Auffächern des durch die Elektronenstrahlen aus mehreren Richtungen überstrichenen Bestrahlungsfeldes versehen.

Zur Vermeidung bzw. Unterdrückung von nachteiligen Einflüssen von das teilchenförmige Material bzw. Schüttgut begleitenden Stoffen, die mit diesem in die Bestrahlungskammer eingetragen werden, auf die Elektronenkanonen, sind diese im Strahlerzeuger mit einer Mehrzahl abfolgend angeordneter Blenden versehen, deren Durchmesser an den zugehörigen Elektronenstrahl angepaßt ist, vorzugsweise bei Verwendung auffächernder Elektronenstrahlen sich in Richtung zur Strahlaustrittsseite hin vergrößert. Zwischen benachbarten Blenden sind, zumindest teilweise, Vakuumerzeuger radial angeschlossen. Es wird ferner bevorzugt, daß zwischen den beiden, dem Strahlenaustritt des Elektronenstrahles aus der zugehörigen Elektronenkanone nächstliegenden Blenden ein drosselbarer Belüftungsanschluß vorgesehen ist.

Gemäß einem bevorzugten Ausführungsbeispiel der Einrichtung nach der vorliegenden Erfindung ist an der Eintrittsstelle des teilchenförmigen Materiales oder Schüttgutes, z.B. von Getreidekörnern, in die Bestrahlungskammer eine Verteilereinrichtung vorgesehen, die mit Hilfe von Leitblechen das Material bzw. Schüttgut über im wesentlichen den gesamten Querschnitt (zumindest in Richtung einer Hauptebene) eines im Anschluß an die Verteilereinrichtung angeordneten Fallschachtes gleichmäßig verteilt. In dem sich an den Fallschacht anschließenden Bestrahlungsbereich sind zumindest zwei Elektronenstrahlerzeuger (Elektronenkanonen), vorzugsweise Axialkanonen, bevorzugt in gleicher Höhe einander radial gegenüberliegend angeordnet. Die zugehörigen Ablenkeinrichtungen der Elektronenkanonen fächern den jeweils zugehörigen Elektronenstrahl breit auf. Jeder Elektronenstrahl wird in herkömmlicher Weise mittels Ablenkgeneratoren periodisch horizontal und vertikal abgelenkt. Die Elektronenkanonen weisen mehrere Blenden auf, deren Durchmesser an die Führung des Elektronenstrahles in der Elektronenkanone angepaßt ist, vorzugsweise nach der Strahlaustrittsseite hin kontinuierlich ansteigt.

Zwischen zunächst der Strahlaustrittsseite und der dieser benachbarten Blende ist vorzugsweise eine mit einem Drosselventil einstellbare Verbindung zur Atmosphäre vorgesehen, die vorzugsweise der Belüftung der Bestrahlungskammer und des zugehörigen Elektronenstrahlerzeugers dient. Gegebenenfalls kann jedoch auf diese Weise auch eine beständige, dosierte Zufuhr eines Strömungsmediums von dem Elektronenstrahlerzeuger zu der Bestrahlungskammer hin erfolgen, die den Eintritt von Staub aus dem Material in der Bestrahlungskammer in die Elektronenkanone zusätzlich verhindert. Zwischen den anderen Blenden sind radial Vakuumerzeuger angeschlossen. Vorzugsweise besitzt die Bestrahlungskammer eine hinreichende Länge in vertikaler Anordnung, um während des freien Falles des teilchenförmigen Materiales bzw. Schüttgutes in dieser die Vereinzelung der Teilchen zu bewirken oder zu unterstützen.

Vorzugsweise sind die Leitbleche der Verteilereinrichtung zum Vereinzeln des teilchenförmigen Materiales bzw. Schüttgutes innerhalb der Bestrahlungskammer (Rezipient) zur Aufteilung des Material- bzw. Schüttgutstromes fächerartig angeordnet.

Weitere, bevorzugte Ausgestaltungen der Erfindung sind in den übrigen Unteransprüchen dargelegt.

Das erfindungsgemäße Verfahren und die erfindungsgemäße Einrichtung sind insbesondere dazu vorgesehen, als Schüttgut bzw. teilchenförmiges Material Saatgut zu behandeln, um an den Samenkörnern des Saatgutes haftende Schaderreger unwirksam zu machen. In allgemeinerer Hinsicht sind das Verfahren und die Einrichtung nach der vorliegenden Erfindung insbesondere zur Eigenschaftsverbesserung von teilchenförmigem Material oder Schüttgut vorgesehen, das mit Feuchtigkeit und/oder Staub belastet ist, wobei diese Begleiter für eine wirksame Behandlung des Materiales mit Elektronenstrahlen im Vakuum zu besonderen Schwierigkeiten im Hinblick auf eine wirksame Prozeßführung und einen Langzeitbetrieb der Elektronenerzeuger, die insbesondere vor Staub geschützt werden müssen, führen.

Neben der Schaderregerbekämpfung an Getreidesaatgut könnten Verfahren und Einrichtung nach der vorliegenden Erfindung z.B. auch für Behandlungen von Granulaten, Katalysatoren oder Keramikkörpern für die chemische Industrie oder in anderen Anwendungsbereichen verwendet werden.

Durch das erfindungsgemäße Verfahren und die erfindungsgemäße Einrichtung zur Behandlung von teilchenförmigem Material bzw. Schüttgut können auch Materialien mit verhältnismäßig ungünstigen Eigenschaften oder in ungünstiger Zusammensetzung für eine Elektronenstrahlbehandlung im Vakuum, z.B. mit hohem Wasser- und Staubgehalt, behandelt werden, obwohl z.B. gerade an dem Material anhaftender Staub von einer Freisetzung in der Bestrahlungskammer und von den Elektronenstrahlerzeugern möglichst ferngehalten werden soll. Diesem Ziel dient bei der vorliegenden Erfindung insbesondere die vakuummäßige Entkopplung, die bei der Zuführung des Materiales zu der Bestrahlungskammer vorgesehen ist.

Die Erfindung wird nachstehend anhand eines Ausführungsbeispieles und zugehöriger Zeichnungen erläutert. In den Zeichnungen zeigen:
Fig. 1 eine schematische Längsschnittdarstellung einer Einrichtung zur Behandlung von Getreidesaatgut nach der vorliegenden Erfindung,
Fig. 2 einen oberen Eingangsbereich der Einrichtung nach Fig. 1 in Teilansicht und in einer Ebene 90° versetzt zur Darstellung gemäß Fig. 1,
Fig. 3 eine schematische Teilansicht der Einrichtung nach Fig. 1 im Bereich der Bestrahlungskammer mit zugeordneten Elektronenstrahlerzeugern,
Fig. 4 ein Stromdichteprofil eines Elektronenstrahles im Bereich eines Bestrahlungsfeldes der Bestrahlungskammer.

Nachfolgend wird ein Ausführungsbeispiel der Erfindung zur Behandlung von teilchenförmigem Material (Schüttgut) erläutert, wobei in diesem Ausführungsbeispiel als teilchenförmiges Material Saatgut, insbesondere Getreide, behandelt wird. Die Erfindung ist selbstverständlich hierauf nicht beschränkt; vielmehr kann als Behandlungsgut auch jedes andere organische und/oder anorganische Material in Teilchenform nach dem Verfahren und in der Einrichtung nach der Erfindung behandelt werden, das einer Bestrahlung mit Elektronenstrahlen unterzogen werden soll.

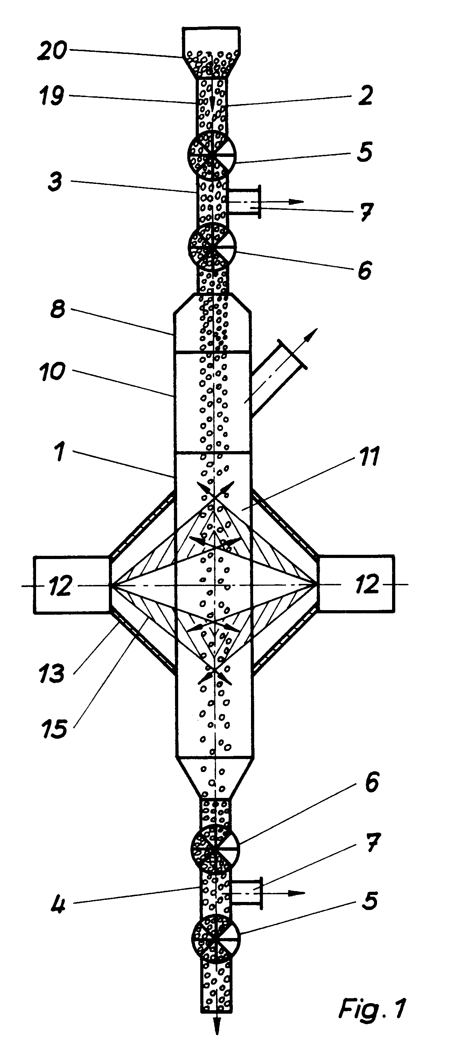

Fig. 1 zeigt in schematischer Längsschnittdarstellung die Verfahrensführung und Einrichtung zur Behandlung von Getreidesaatgut mit Elektronenstrahlen.

An einer Bestrahlungskammer 1 (Rezipient) sind zum Einbringen und Ausgeben und zur Bildung eines kontinuierlichen Stromes aus Getreidekörnern 2 Druckstufen 3, 4 vorgesehen, die jeweils aus zwei Zellenradschleusen 5, 6 sowie einem Anschluß 7 für Druckpumpen, insbesondere Vakuumpumpen, bestehen, um einen allmählichen Druckabbau auf dem Wege der Getreidekörner 2 zu der evakuierten Bestrahlungskammer 1 zu erreichen und die gewünschten Druckbedingungen für eine sich gegebenenfalls anschließende weitere Behandlung bzw. Abförderung der Getreidekörner 2 nach Verlassen der Bestrahlungskammer 1 zu gewährleisten. Gegebenenfalls können sowohl eingangsseitig als auch ausgangsseitig, insbesondere in Abhängigkeit von der zu steuernden Druckdifferenz, mehrere Druckstufen 3, 4 hintereinander angeordnet sein. Die Getreidekörner 2 können eingangsseitig in die Einrichtung aus einem Silo 20 oder einem anderen Getreidevorratsbehälter aufgegeben werden.

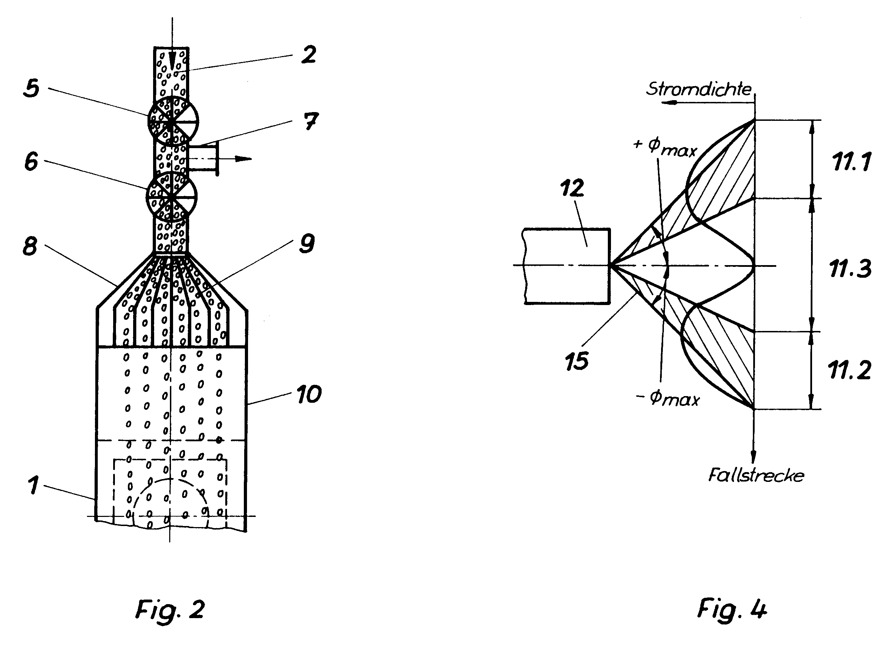

Wie insbesondere Fig. 2 verdeutlicht, die einen Übergangsbereich zwischen der Bestrahlungskammer 1 und der eingangsseitigen Druckstufe zur Zuförderung des Materialstromes aus Getreidekörnern 2 zeigt, ist in einem Übergangsbereich zur Bestrahlungskammer 1 im Anschluß an die vorangehende Druckstufe 3 mit den Zellenradschleusen 5, 6 eine Verteilereinrichtung 8 zur Vereinzelung der Getreidekörner 2 vorgesehen. Diese Verteilereinrichtung 8 besitzt fächerartig angeordnete Leitbleche 9, die den Strom aus Getreidekörnern 2 über einen größeren Querschnittsbereich aufteilen.

Die vereinzelten Getreidekörner 2 gelangen von dem sich an die Verteilereinrichtung 8 anschließenden Fallschacht 10, der bereits einen Teil der evakuierten Bestrahlungskammer 1 bildet, im freien Fall in ein Bestrahlungsfeld 11 der evakuierten Bestrahlungskammer und füllen den Querschnitt derselben zumindest in Richtung einer durch die Verteilereinrichtung 8 bestimmten Hauptebene im wesentlichen vollständig aus. Das Bestrahlungsfeld wird durch zwei einander gegenüberliegende, über Scanner 13 angeflanschte Elektronenkanonen 12 bestimmt. Durch die beiden, einander diametral gegenüberliegenden Elektronenkanonen 12 wird jedes Getreidekorn 2 zweiseitig annähernd zeitgleich bestrahlt. Dadurch wird erreicht, daß die während des freien Falls sich auch drehenden Getreidekörner 2 allseitig bestrahlt werden. Bedingt durch die Anordnung und Ausbildung der Leitbleche 9 der Verteilereinrichtung 8 haben die Getreidekörner 2 auch eine annähernd gleiche Geschwindigkeit und weisen voneinander zumindest der Korngröße entsprechenden Abstand beim Durchgang durch das Bestrahlungsfeld 11 auf.

Die Elektronenkanonen 12 erzeugen je einen Elektronenstrahl 15, wobei die Elektronenstrahlen 15 vertikal und horizontal in der Zeichenebene von Fig. 2 so aufgefächert werden, daß sie den gesamten Querschnitt des Materialstromes aus den Getreidekörnern 2 erfassen. Die in Richtung der Bestrahlung durch die Elektronenstrahlen 15 bestehende Transparenz des Schüttgutstromes aus den Getreidekörnern 2 in dem Bestrahlungsfeld 11 beträgt vorzugsweise ca. 50%, um die gegenseitige Abschattung von Getreidekörnern 2 im wesentlichen zu vermeiden. Selbstverständlich ist es auch möglich, bei höherer Transparenz des Materialstromes aus Getreidekörnern 2 unter Inkaufnahme höherer Verlustleistungsanteile zu arbeiten.

Die Ablenkfunktionen für die Elektronenstrahlerzeuger sind so gewählt, daß die Strahlleistung gleichmäßig auf die Breite des Schüttgutstromes verteilt wird und daß in Fallrichtung der Getreidekörner 2 ein Stromdichteprofil im Bestrahlungsfeld 11 entsteht, wie es in Fig. 4 dargestellt ist. Dieses Bestrahlungsfeld 11 ist vorzugsweise in drei Bereiche unterteilt, die in Fallrichtung der Getreidekörner aufeinander abfolgen und von denen zwei Bestrahlungsbereiche 11.1 und 11.2 eine hohe Stromdichte aufweisen, wobei diese Bestrahlungsbereiche 11.1, 11.2 durch einen Bestrahlungsbereich 11.3 mit einer geringen oder verschwindenden Stromdichte voneinander getrennt sind. Hierdurch wird infolge der Winkelstreuung der Elektronen ohne nennenswerten Energieverlust die Dosishomogenität über die Oberfläche der Getreidekörner 2 verbessert. Um zu vermeiden, daß sich Getreidekörner 2 gegenseitig abschatten, wird die Verteilung des Schüttgutstromes aus Getreidekörnern 2 in der Bestrahlungskammer 1 so gewählt, daß sich die Getreidekörner 2 in einem solchen mittleren Abstand voneinander bewegen, daß sie infolge des Ablenkwinkels eines Elektronenstrahles 15 mindestens in einem der Bestrahlungsfelder 11.1 oder 11.2 vom Elektronenstrahl 15 erreicht werden. Für einen vertikalen Ablenkwinkel von 45° ist dazu ein mittlerer Abstand erforderlich, der der Kornabmessung entspricht. Durch die weitgehende Verminderung der Stromdichte im Mittenbereich des Bestrahlungsfeldes 11 wird verhindert, daß sensible Baugruppen der Elektronenkanonen 12 der opponierend angeordneten Elektronenkanonen 12 durch die Elektronenstrahlen 15 wesentlich belastet werden. Die Ausbildung des Bestrahlungsfeldes 11 mit den Bestrahlungsfeldern 11.1 und 11.2 hoher Stromdichte wird durch die Ablenkfunktionen in vertikaler und horizontaler Richtung bestimmt. Die Zeilenfrequenz wird derart festgelegt, daß die Fallzeit der Körner durch das Bestrahlungsfeld 11.1 und 11.2 mehrere, z.B. 10 Ablenkperioden umfaßt. Die Dichte des Zeilenrasters, bestimmt durch das Verhältnis von Zeilenfrequenz zu Bildfrequenz, bestimmt die Homogenität der Stromdichteverteilung in Fallrichtung der Getreidekörner. Es wird bevorzugt, die Zeilenfrequenz des Elektronenstrahles 15 jeweils bei einigen kHz und die Bildfrequenz im Bereich einiger 10 Hz bis einige 100 Hz zu wählen. Durch die Wahl dieser Parameter der Ablenkfunktion können in vorteilhafter Weise Elektronenstrahlleistungsverluste infolge eines längeren Strahlweges bis zur Hauptebene des Schüttgutstromes der Getreidekörner 2 sowie Ausblendungen und andere Einflüsse kompensiert werden.

Eine weitere, vorteilhafte Maßnahme zur Verbesserung der Homogenität der Oberflächendosis auf den bestrahlten Getreidekörnern 2 wird dadurch erreicht, daß in der Bestrahlungskammer 1 ein Evakuierungsdruck von ca. 10 Pa bis einige 100 Pa, insbesondere ca. 100 Pa bis einige 100 Pa eingestellt wird, wodurch eine Winkelstreuung der beschleunigten Elektronen ohne störende Energieverluste erreicht wird.

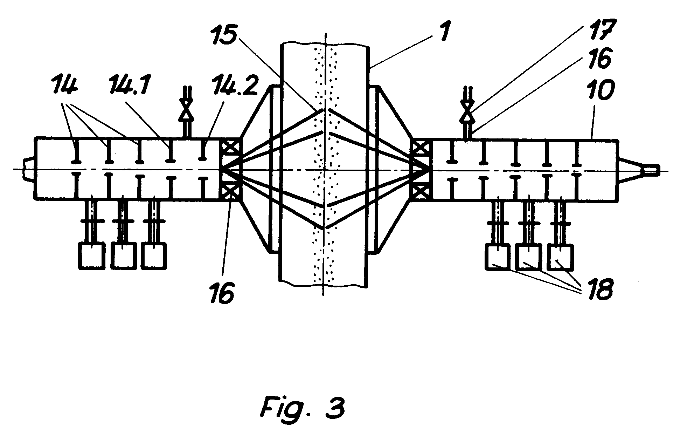

Die Elektronenkanonen 12 besitzen, wie in der Teildarstellung gemäß Fig. 3 gezeigt ist, jeweils abfolgend mehrere Blenden 14, deren Durchmesser sich im vorliegenden Fall in Richtung vom Strahlerzeuger zum Austritt des Elektronenstrahles 15 hin stetig vergrößert. Zwischen der austrittsseitig letzten Blende 14.2 und der vorangehenden Blende 14.1 ist ein Anschluß 16 in die Atmosphäre über ein Ventil 17 vorgesehen. Zwischen den übrigen Blenden 14 sind jeweils Vakuumerzeuger 18 angeschlossen. Auf diese Weise kann das Eindringen von Fremdkörpern, insbesondere von Wasserdampf und Staub, von den Getreidekörnern in der Behandlungskammer 1 in die Elektronenkanonen 12 wirksam verhindert werden. Das Ventil 17 dient der Belüftung der Einrichtung, wobei Luftströmungen beim Anpumpen und Belüften stets von der Elektronenkanone 12 weg zur Bestrahlungskammer 1 hin bzw. in Verbindung mit dem Evakuierungsregime stets von der Elektronenkanone 12 und der Bestrahlungskammer 1 nach der Atmosphärendruckseite hin gerichtet werden. Gegebenenfalls kann ein derartiger Anschluß 16 aber auch verwendet werden, um einen beständigen, dosierten Strom eines Strömungsmediums von der Elektronenkanone 12 zur Bestrahlungskammer 1 hin zu erzeugen, um das Eindringen von Staub in die Elektronenkanone 12 zusätzlich zu behindern.

Nach Passieren des Bestrahlungsbereiches 11 im freien Fall in der evakuierten Bestrahlungskammer 1 werden die Getreidekörner 2 ausgangsseitig von einer bodenseitigen Austrittsöffnung der Bestrahlungskammer 1 durch die Druckstufe 4 mit den Zellenradschleusen 6, 5 unter Drucksteuerung am Anschluß 7 durch eine Vakuumpumpe oder andere Drucksteuereinrichtungen in Abhängigkeit von dem im Anschluß an die Elektronenstrahlbehandlung gewünschten Druckregime bei dem Weitertransport der Getreidekörner 2 abgeführt.

In Abhängigkeit von den Behandlungsbedingungen, insbesondere der Ausbildung und Steuerung der Querschnittsverteilung eines Materialstromes innerhalb der Bestrahlungskammer 1 durch die Verteilereinrichtung 8 ist es selbstverständlich auch möglich, eine andere Zahl von Elektronenstrahlerzeugern in anderer radialer und/oder axialer Zuordnung zu der Bestrahlungskammer 1 anzuordnen. Wesentlich ist lediglich, daß durch Zusammenwirken der Aufbereitung des Material- oder Schüttgutstromes zur Vereinzelung der Teilchen beim Fall durch die Bestrahlungskammer mit der Anordnung und radialen oder axialen Verteilung der Elektronenstrahlerzeuger an der Bestrahlungskammer unter Berücksichtigung der Eigenbewegung der Teilchen des Material- bzw. Schüttgutstromes eine allseitige Bestrahlung der einzelnen Teilchen des Material- oder Schüttgutstromes bei möglichst homogener Oberflächendosisverteilung erreicht wird. Bei einem im wesentlichen "scheibenförmigen" Querschnitt des Stromes aus Getreidekörnern 2, wie im vorliegenden Ausführungsbeispiel in den Fig. 1 und 2 gezeigt, ist die Anordnung gegenüberliegender Elektronenstrahlerzeuger 12 für ein gutes Bestrahlungsergebnis hinreichend. In Abhängigkeit von der Konfiguration der Anordnung der Elektronenstrahlerzeuger zur Ausbildung eines Bestrahlungsfeldes ist es selbstverständlich auch möglich, ein anderes Stromdichteprofil als dasjenige auszubilden, das in Fig. 4 dargestellt ist. Die Abstimmung dieser Parameter hängt von der Art des zu behandelnden Gutes, der räumlichen Verteilung des Gutes im Bestrahlungsfeld dem gewünschten Bestrahlungsergebnis und anderen Faktoren ab.

Durch die gegenüberliegende Anordnung der Elektronenkanonen 12 gemäß Fig. 1 und die Ablenkung sowie breite Auffächerung der Elektronenstrahlen 15 in bezug auf die Elektronenkanonen 12 schräg nach oben sowie schräg nach unten können die Getreidekörner 2 den Elektronenstrahlen 15 ausreichend lange und allseitig ausgesetzt werden.

Wie gezeigt, werden die Getreidekörner 2 aus dem Silo 20 über eine oder mehrere Druckstufen 3 zu der Vereinzelungsvorrichtung 8 und die Bestrahlungskammer 1 zugefördert. Der Druck in der Druckstufe 3 bzw. zwischen den einzelnen Druckstufen 3 wird durch die einzelnen Vakuumerzeuger, verbunden mit den Anschlüssen 7 in jeder Druckstufe 3 so eingestellt, daß der Dampfdruck des Wassers, das sich in der oberflächennahen Schicht der Getreidekörner 2 befindet, nicht unterschritten wird. Infolge dieser Druckeinstellung wird der Gesamtevakuierungsaufwand für die Vakuumerzeuger minimiert. Durch die Zellenradschleuse 6 wird das Schüttgut bzw. werden die Getreidekörner 2 schnell in die Bestrahlungskammer 1 überführt, in der sie sich im freien Fall unter einem Druck, der durch die Anforderungen des Elektronenstrahles 15, der auf die vereinzelten Getreidekörner 2 einwirkt, bestimmt wird und der vorzugsweise ca. 100 Pa bis einige 100 Pa beträgt, bewegen. Durch dieses Förderprinzip ist die Aufenthaltsdauer der Getreidekörner 2 in der Bestrahlungskammer 1 sehr gering, wodurch die Wasserabgabe aus den Getreidekörnern 2 und der Evakuierungsaufwand gering gehalten werden. Eine weitere Verringerung der Wasserdampfabgabe wird durch die schlagartige Temperatursenkung bewirkt, die durch den schnellen Übergang vom Druck in der letzten Stufe des Druckstufen-Schleusensystemes auf der Zuführungsseite (Druckstufe 3) auf den Arbeitsdruck in der Bestrahlungskammer 1 entsteht. Diese Temperaturabsenkung bleibt aufgrund der vergleichsweise großen Zeitkonstante für den Temperaturausgleich im Getreidekorn 2 auf die oberflächennahe Schicht des Getreidekornes 2 begrenzt. Infolge dieser Temperaturabsenkung sinkt auch die Verdampfungsrate auf der Kornoberfläche.

Die eingangsseitige Zellenradschleuse 5 ist vorzugsweise drehzahlgesteuert und dient gleichzeitig als Dosiereinrichtung. Sie bildet in einer Leitung 19 stromauf der Druckstufe 3 eine Säule aus dem Schüttgut, hier den Getreidekörnern 2, die als zusätzlicher Strömungswiderstand wirksam ist, wenn die Länge dieser angestauten Säule aus Getreidekörnern 2 groß ist gegen die Querschnittsabmessungen dieser Säule.

Die Ausschleusung der Getreidekörner 2 aus der Bestrahlungskammer 1 geschieht in analoger Weise im Vorgang des Einschleusens, wobei der jeweilige Druck in den einzelnen Druckstufen 4 ebenfalls oberhalb des Dampfdruckes des Wassers gehalten wird. Durch die Druckstufe 4 oder eine Mehrzahl derselben in Reihenanordnung im Anschluß an die Bestrahlungskammer 1 wird der Förderdruck stufenweise wieder auf Atmosphärendruck angehoben. Auch hierbei dienen die Zellenradschleusen 5, 6 zugleich der Dosierung des Getreidekornstromes. Wie auch vor der ersten Zellenradschleuse 5 ist es vorteilhaft, auch vor der letzten Zellenradschleuse 5 auf der Ausgabeseite je einen Leitungsabschnitt vorzusehen, dessen Länge groß gegenüber seinem Querschnitt ist, um auch hier einen zusätzlichen Strömungswiderstand auszubilden. Die Zellenradschleuse 6 im Anschluß an die Bestrahlungskammer 1 bildet ebenfalls vorzugsweise eine drehzahlgesteuerte Dosiereinrichtung.

Im vorliegenden Ausführungsbeispiel wurde die Erfindung anhand der Elektronenbehandlung eines Stromes aus Getreidekörnern zur Behandlung derselben gegen samenbürtige Schaderreger dargestellt, wobei dieses Verfahren und die zugehörige Einrichtung zu einer Bestrahlung des Saatgutes führt, die ohne ertragswirksame Schäden ein breites fungizides Wirkungsspektrum aufweist. Durch die vakuumentkoppelnde, über Druckstufen erfolgende Führung des Saatgutes zu der Bestrahlungskammer 1 hin und von dieser weg, gelingt es auch, den an dem Saatgut anhaftenden Staub von der Behandlungskammer und den Elektronenstrahlerzeugern weitgehend fernzuhalten. Überdies wird eine hohe Durchsatzleistung bei geringen Verweilzeiten in der Bestrahlungskammer erreicht und trotz des hohen Wassergehaltes des Saatgutes eine beträchtliche Erhöhung des Evakuierungsaufwandes vermieden.

Das Verfahren und die Einrichtung nach der vorliegenden Erfindung eignen sich daher in besonderem Maße für eine kontinuierliche Behandlung von Saatgut, insbesondere Getreide, in einem kontinuierlichen Verfahren zur Schaderregerbekämpfung, ohne daß die Erfindung hierauf beschränkt wäre. Vielmehr kann auch anderes teilchenförmiges Material, Granulate, Keramikkügelchen etc. zur allseitigen Bestrahlung mit Elektronenstrahlen sowie andere Arten von Schüttgut durch das erfindungsgemäße Verfahren und in der Einrichtung nach der vorliegenden Erfindung behandelt werden. Die Führung des Evakuierungsregimes, die Anordnung und Verteilung von insbesondere mehr als zwei Elektronenstrahlerzeugern am Rezipienten sowie die Ausbildung des Bestrahlungsfeldes und die Wahl des Strömungsquerschnittes des Materialstromes in der Bestrahlungskammer in Verbindung mit der Zuführung und Abführung des Materialstromes über ein Druckstufen-Schleusensystem kann je nach Bestrahlungsaufgabe entsprechend modifiziert werden. Die Erfindung führt dabei zu einer wesentlichen Verbesserung der Durchsatzleistung bei homogener Dosisverteilung über die gesamte Oberfläche des teilchenförmigen bzw. Schüttgutmateriales.

## Patentansprüche

1. Verfahren zur Behandlung von Schüttgut aus teilchenförmigem Material, insbesondere Saatgut, mit Elektronenstrahlen in einem Bestrahlungsfeld einer Bestrahlungskammer, durch die das Schüttgut hindurch bewegt, einer Elektronenstrahlbehandlung mit mehreren Elektronenstrahlen unterzogen und anschließend aus der Bestrahlungskammer abgeführt wird, **dadurch gekennzeichnet,** daß das Schüttgut dosiert und unter Vereinzelung an einer Eintrittsseite der evakuierten Bestrahlungskammer (1) zur Bildung eines kontinuierlichen Materialstromes aus vereinzeltem, teilchenförmigen Material im freien Fall durch die evakuierte Bestrahlungskammer (1) geführt, die Elektronenstrahlen (15) in Fallrichtung des Materiales aufgefächert werden und in dem Bestrahlungsfeld (11) eine im wesentlichen allseitige Bestrahlung des vereinzelten, teilchenförmigen Materiales durch die aufgefächerten Elektronenstrahlen (15) mehrseitig aus unterschiedlichen Richtungen erfolgt.

2. Verfahren nach Anspruch 1, **dadurch gekennzeichnet,** daß das teilchenförmige Material über zumindest eine Druckstufe (3) der Bestrahlungskammer (1) zugeführt und über zumindest eine weitere Druckstufe (4) aus der Bestrahlungskammer (1) abgeführt wird.

3. Verfahren nach Anspruch 2, **dadurch gekennzeichnet,** daß die Zuführung des Materiales in die Bestrahlungskammer (1) unter möglichst geringer Freisetzung von Wasser und/oder Gasen und/oder Staub von dem teilchenförmigen Material (2) erfolgt.

4. Verfahren nach zumindest einem der vorhergehenden Ansprüche 1 bis 3, **dadurch gekennzeichnet,** daß das teilchenförmige Material (2) in dem Bestrahlungsfeld (11) durch die Elektronenstrahlen (15) zumindest teilweise entlang eines Weges beaufschlagt wird, der oberhalb der Auztrittsstelle des Elektronenstrahls (15) aus einem Elektronenstrahlerzeuger (12) beginnt und unterhalb derselben endet.

5. Verfahren nach zumindest einem der vorhergehenden Ansprüche 1 bis 4, **dadurch gekennzeichnet,** daß die Teilchen des Materialstromes in einer Vereinzelung mit einer Transparenz im Bestrahlungsbereich des Bestrahlungsfeldes (11) von ca. 50% und einem mittleren Abstand der Teilchen quer zur Strömungsrichtung des Materialstromes, der größer ist als die Teilchengröße, durch die Bestrahlungskammer (1), insbesondere das Bestrahlungsfeld (11), passieren.

6. Verfahren nach zumindest einem der vorhergehenden Ansprüche 1 bis 5, **dadurch gekennzeichnet,** daß ein Stromdichteprofil der Elektronenstrahlen (15) im Bestrahlungsfeld (11) eingestellt wird, derart, daß eine Oberflächendosis der das Bestrahlungsfeld (11) passierenden Teilchen des Materialstromes im wesentlichen homogen über die Oberfläche derselben verteilt ist.

7. Verfahren nach zumindest einem der vorhergehenden Ansprüche 1 bis 6, **dadurch gekennzeichnet,** daß das Bestrahlungsfeld (11) der Elektronenstrahlen (15) so gewählt wird, daß zwei in Strömungsrichtung des Materialstromes abfolgende, über den Strömungsquerschnitt des Materialstromes hinreichend gleichmäßig beaufschlagte Bereiche (11.1; 11.2) hoher Stromdichte durch einen Bereich (11.3) verminderter Stromdichte voneinander getrennt sind.

8. Verfahren nach zumindest einem der vorhergehenden Ansprüche 1 bis 7, **dadurch gekennzeichnet,** daß durch Steuerung des Evakuierungsregimes in der Bestrahlungskammer (1) und den Elektronenstrahlerzeugern (12) Evakuierungsprodukte, wie z.B. Staub, aus dem teilchenförmigen Material (2) an einer Einströmung in die Elektronenstrahlerzeuger (12) gehindert werden, vorzugsweise Gasströmungen in der Bestranlungskammer (1) stets einer Abströmung von den Elektronenstrahlerzeugern (12) weg unterliegen.

9. Verfahren nach zumindest einem der vorhergehenden Ansprüche 1 bis 8, **dadurch gekennzeichnet,** daß durch Steuerung des Evakuierungsregimes Luftströmungen beim Evakuieren und beim Belüften stets von dem Elektronenstrahlerzeuger (12) und der Bestrahlungskammer (1) nach der Atmosphärendruckseite hin gerichtet sind.

10. Verfahren nach zumindest einem der vorhergehenden Ansprüche 1 bis 9, **dadurch gekennzeichnet,** daß in der Bestrahlungskammer (1) ein Druck von ca. 10 Pa bis einige 100 Pa eingestellt wird.

11. Verfahren nach zumindest einem der vorhergehenden Ansprüche 1 bis 10, **dadurch gekennzeichnet,** daß eine Zeilenfrequenz der Elektronenstrahlen (15) auf mehrere kHz und eine Bildfrequenz auf ca. einige 10 Hz bis einige 100 Hz eingestellt wird.

12. Einrichtung zur Behandlung von Schüttgut aus teilchenförmigem Material, insbesondere Saatgut, mit Elektronenstrahlen in einer vertikal angeordneten Bestrahlungskammer, die eine obere Eintrittsöffnung und eine untere Austrittsöffnung für das Schüttgut aufweist und an der radial mehrere Elektronenstrahlerzeuger angeordnet sind, **dadurch gekennzeichnet,** daß die Bestrahlungskammer (1) evakuiert und an ihrem oberen Ende mit einer Verteilereinrichtung (8, 9) zur Vereinzelung des teilchenförmigen Materiales versehen ist, und die Elektronenstrahlerzeuger (12) mit Ablenkeinrichtungen zum Auffächern der Elektronenstrahlen (15) versehen sind, zur Bildung eines Bestrahlungsfeldes (11), durch das das aus der Verteilereinrichtung (8, 9) austretende teilchenförmige Material (2) im freien Fall geführt ist.

13. Einrichtung nach Anspruch 12,
**gekennzeichnet durch** eine Bestrahlungskammer (1) mit an dieser angeordneten Elektronenkanonen (12) und je einem Druckstufen-Schleusensystem (3, 4) zum Einund Ausschleusen des Schüttgutes (2) mit zwischen diesen angeordneten Vakuumpumpen, wobei die Druckstufen aus mehreren Zellenradschleusen (5, 6) zusammengesetzt sind und an einer Eintrittsstelle des Schüttgutes (2) in die Bestrahlungskammer (1) eine Verteilereinrichtung (8) für die Vereinzelung desselben über in wesentlichen den gesamten Querschnitt der Bestrahlungskammer (1) angeordnet ist, die Bestrahlungskammer (1) einen Fallschacht (10) für das Schüttgut (2) im Anschluß an die Verteilereinrichtung (8) aufweist, im Bereich des freien Falls des Schüttgutes innerhalb der Bestrahlungskammer (1) mit dieser mindestens zwei Elektronenkanonen (12) mit Ablenkeinrichtung zum Auffächern des Elektronenstrahles (15) radial zum Schüttgutstrom angeordnet sind, die Elektronenkanonen (12) jeweils mehrere Blenden (14) mit an den Elektronenstrahl (15) angepaßtem Öffnungsdurchmesser aufweisen, wobei zwischen einer der Strählaustrittsseite nächstliegenden Blende (14.2) und einer benachbarten Blende (14.1) ein Anschluß (16) zur Belüftung der Bestrahlungskammer (1) über ein Ventil (17) angebracht ist und zwischen den weiteren Blenden (14) der Elektronenkanonen (12) jeweils Vakuumerzeuger (18) angeordnet sind.

14. Einrichtung nach Anspruch 12 oder 13, **dadurch gekennzeichnet,** daß die Verteilereinrichtung (8) fächerartig angeordnete Leitbleche (9) aufweist.

15. Einrichtung nach zumindest einem der Ansprüche 12 bis 14, **dadurch gekennzeichnet,** daß an der Bestrahlungskammer (1) diametral einander gegenüberliegend in gleicher Höhe zwei Elektronenkanonen (12) angeordnet sind und die Bestrahlungskammer (1) eine axiale Länge aufweist, derart, daß das Schüttgut (2) während des freien Falles im Bestrahlungsfeld (11) vereinzelt ist.

16. Einrichtung nach zumindest einem der vorhergehenden Ansprüche 12 bis 15, **dadurch gekennzeichnet,** daß in den Elektronenkanonen (12) jeweils eine Mehrzahl von Blenden (14.1, 14.2) angeordnet ist, deren Durchmesser nach der Strahlenaustrittsseite der Elektronenkanone (12) zunimmt.

17. Einrichtung nach zumindest einem der vorhergehenden Ansprüche 12 bis 16, **dadurch gekennzeichnet,** daß zumindest die eingangsseitig vom Atmosphärendruck beaufschlagte Zellenradschleuse (5) eine Drehzahlsteuerung aufweist.

18. Einrichtung nach Anspruch 17, **dadurch gekennzeichnet,** daß der Zellenradschleuse (5) zum Einbringen des teilchenförmigen Materiales bzw. Schüttgutes (2) eine Dosiereinrichtung vorgeschaltet ist.

## Claims

1. Method for one treatment of bulk, particle-shaped material, in particular seed, with electron beams in an irradiation field of an irradiation chamber, through which the bulk material is conveyed, is subjected to an electron beam treatment by a plurality of electron beams and is then discharged from the irradiation chamber, **characterized in that** the bulk material, dosed and simultaneously separated out at an inlet end of the evacuated irradiation chamber (1) to form a continuous stream of separated, particle-shaped material, is conveyed in free fall through the evacuated irradiation chamber (1), the electron beams (15) are fanned out in the direction of fall of the material, and in the irradiation field (11) a substantially all-round irradiation of the separated, particle-shaped material is effected by the fanned-out electron beams (15) on a plurality of sides from different directions.

2. Method according to claim 1, **characterized in that** the particle-shaped material is supplied via at least one pressure stage (3) to the irradiation chamber (1) and is discharged via at least one further pressure stage (4) from the irradiation chamber (1).

3. Method according to claim 2, **characterized in that** the supply of the material into the irradiation chamber (1) is effected with the least possible liberation of water and/or gases and/or dust from the particle-shaped material (2).

4. Method according to at least one of the preceding claims 1 to 3, **characterized in that** the particle-shaped material (2) in the irradiation field (11) is acted upon by the electron beams (15) at least partially along a path which begins above the exit point of the electron beam (15) from an electron gun (12) and ends below said exit point.

5. Method according to at least one of the preceding claims 1 to 4, **characterized in that** the particles of the material stream pass through the irradiation chamber (1), in particular through the irradiation field (11), in a separated state with a transparency in the irradiation region of the irradiation field (11) of approximately 50% and with a mean distance apart of the particles perpendicular to the flow direction of the material stream which is greater than the particle size.

6. Method according to at least one of the preceding claims 1 to 5, **characterized in that** a current density profile of the electron beams (15) in the irradiation field (11) is adjusted in such a way that a surface dose of the particles of the material stream passing the irradiation field (11) is distributed substantially uniformly over the surface of said particles.

7. Method according to at least one of the preceding claims 1 to 6, **characterized in that** the irradiation field (11) of the electron beams (15) is so selected that two regions (11.1; 11.2) of high current density, which succeed one another in the direction of flow of the material stream and are acted upon sufficiently uniformly over the flow cross-section of the material stream, are separated from one another by a region (11.3) of reduced current density.

8. Method according to at least one of the preceding claims 1 to 7, **characterized in that,** by controlling the evacuation regime in the irradiation chamber (1) and the electron guns (12), evacuation products such as, for example, dust from the particle-shaped material (2) are prevented from flowing into the electron guns (12), gas flows in the irradiation chamber (1) preferably always being subject to a discharge action away from the electron guns (12).

9. Method according to at least one of the preceding claims 1 to 8, **characterized in that,** by controlling the evacuation regime, air currents during evacuation and during aeration are always directed from the electron gun (12) and the irradiation chamber (1) towards the atmospheric pressure end.

10. Method according to at least one of the preceding claims 1 to 9, **characterized in that** a pressure of around 10 Pa to several 100 Pa is adjusted in the irradiation chamber (1).

11. Method according to at least one of the preceding claims 1 to 10, **characterized in that** a line frequency of the electron beams (15) is set at several kHz and a frame frequency is set at around several 10 Hz to several 100 Hz.

12. Device for the treatment of bulk, particle-shaped material, in particular seed, using electron beams in a vertically disposed irradiation chamber, which has a top inlet opening and a bottom outlet opening for the bulk material and against which a plurality of electron guns are radially disposed, **characterized in that** the irradiation chamber (1) is evacuated and is provided at its top end with a distributor device (8, 9) for separating out the particle-shaped material, and the electron guns (12) are provided with deflection devices for fanning out the electron beams (15) to form an irradiation field (11), through which the particle-shaped material (2) emerging from the distributor device (8, 9) is conveyed in free fall.

13. Device according to claim 12,
**characterized by** an irradiation chamber (1) having electron guns (12) disposed thereon and one pressure stage lock system (3, 4) each for inward and outward transfer of the bulk material (2), between which vacuum pumps are disposed, wherein the pressure stages comprise a plurality of star feeder locks (5, 6) and a distributor device (8) is disposed at an inlet point of the bulk material (2) into the irradiation chamber (1) for separating out said material over substantially the entire cross-section of the irradiation chamber (1), the irradiation chamber (1) has a fall shaft (10) for the bulk material (2) adjoining the distributor device (8), at least two electron guns (12) with a deflection device for fanning out the electron beam (15) more radially relative to the bulk material stream are disposed in the region of free fall of the bulk material inside the irradiation chamber (1) with said chamber, the electron guns (12) each have a plurality of screens (14) with an aperture diameter adapted to the electron beam (15), wherein a connection (16) for aerating the irradiation chamber (1) via a valve (17) is mounted between a screen (14.1) lying nearest to the beam exit end and an adjacent screen (14.2) and vacuum generators (21) are disposed between each of the further screens (14).

14. Device according to claim 12 or 13, **characterized in that** the distributor device (8) comprises baffle plates (9) which are disposed in a fan-like manner.

15. Device according to at least one of claims 12 to 14, **characterized in that** two electron guns (12) are disposed diametrically opposite one another at the same level on the irradiation chamber (1) and the irradiation chamber (1) has an axial length such that the bulk material (2) is separated out during free fall in the irradiation field (11).

16. Device according to at least one of the preceding claims 12 to 15, **characterized in that** disposed in each of the electron guns (12) is a plurality of screens (14.1, 14.2), whose diameter increases towards the beam exit end of the electron gun (12).

17. Device according to at least one of the preceding claims 12 to 16, **characterized in that** at least the star feeder lock (5) acted upon at the inlet end by atmospheric pressure has a rotational speed control.

18. Device according to claim 17, **characterized in that** a dosing device is installed upstream of the star feeder lock (5) for introducing the particle-shaped material or bulk material (2).

## Revendications

1. Procédé de traitement de vrac constitué de matériau en forme de particules, en particulier de semences, par des faisceaux électroniques dans un champ d'irradiation d'une chambre d'irradiation à travers laquelle le vrac passe, est soumis à un traitement par faisceaux électroniques avec plusieurs faisceaux électroniques et est ensuite évacué hors de la chambre d'irradiation, caractérisé par le fait que le vrac est dosé et que, après dissociation à un côté d'entrée de la chambre d'irradiation (1), mise sous vide, pour former un flux de matériau continu constitué de matériau dissocié, en forme de particules, le vrac est dirigé, en chute libre, à travers la chambre d'irradiation (1), mise sous vide, que les faisceaux électroniques (15) s'élargissent en éventail dans la direction de la chute du matériau et qu'il s'opère, sensiblement de tous les côtés, une irradiation du matériau dissocié, en forme de particules, par les faisceaux électroniques (15), élargis en éventail, de plusieurs côtés et en provenance de directions différentes.

2. Procédé selon la revendication 1, caractérisé par le fait que l'on introduit le matériau en forme de particules par l'intermédiaire d'au moins un étage de pression (3) de la chambre d'irradiation (1) et qu'on l'évacue hors de la chambre d'irradiation (1) par l'intermédiaire d'au moins un autre étage de pression (4).

3. Procédé selon la revendication 2, caractérisé par le fait que l'introduction du matériau dans la chambre d'irradiation (1) se fait en libérant du matériau en forme de particules (2) le moins possible d'eau et/ou de gaz et/ou de poussière.

4. Procédé selon au moins l'une des revendications précédentes 1 à 3, caractérisé par le fait que le matériau en forme de particules (2) est, dans le champ d'irradiation (11), soumis aux faisceaux électroniques (15) au moins partiellement le long d'un chemin qui commence au-dessus de la position de sortie du faisceau électronique (15) hors d'un générateur de faisceaux électroniques et qui se termine en-dessous de celle-ci.

5. Procédé selon au moins l'une des revendications précédentes 1 à 4, caractérisé par le fait que les particules du flux de matériau passent à travers la chambre d'irradiation (1), en particulier à travers le champ d'irradiation (11), en étant séparées les unes des autres avec, dans la zone d'irradiation du champ d'irradiation (11), une transparence d'environ 50% et une distance moyenne des particules, perpendiculairement à la direction d'écoulement du flux de matériau, qui est supérieure à la dimension des particules.

6. Procédé selon au moins l'une des revendications précédentes 1 à 5, caractérisé par le fait que l'on règle un profil de densité de courant des faisceaux électroniques (15) dans le champ d'irradiation (11) de façon qu'une dose de surface des particules du flux de matériau passant à travers le champ d'irradiation (11) soit répartie de façon sensiblement homogène sur la surface de celles-ci.

7. Procédé selon au moins l'une des revendications précédentes 1 à 6, caractérisé par le fait que l'on choisit le champ d'irradiation (11) des faisceaux électroniques (15) de façon que deux zones (11.1 ; 11.2), de densité de courant élevée, qui se suivent dans le sens de l'écoulement du flux de matériau et sont exposées suffisamment régulièrement sur la section de l'écoulement du flux de matériau, soient séparées l'une de l'autre par une zone (11.3) de moindre densité d'intensité.

8. Procédé selon au moins l'une des revendications précédentes 1 à 7, caractérisé par le fait qu'en commandant le régime de mise sous vide dans la chambre d'irradiation (1) ainsi que les générateurs (12) de faisceaux électroniques, on empêche les produits résultant de la mise sous vide, comme par exemple la poussière sortant du matériau en forme de particules (2) de s'écouler dans les générateurs (12) de faisceaux électroniques, et que de préférence des flux de gaz dans la chambre d'irradiation (1) sont toujours soumis à un écoulement qui les éloigne des générateurs (12) de faisceaux électroniques.

9. Procédé selon au moins l'une des revendications précédentes 1 à 8, caractérisé par le fait que grâce à la commande du régime de mise sous vide, les écoulements de l'air, lors de mise sous vide et de la remise en air, sont toujours orientés, depuis le générateur (12) de faisceaux électroniques et depuis la chambre d'irradiation (1), vers le côté sous pression atmosphérique.

10. Procédé selon au moins l'une des revendications précédentes 1 à 9, caractérisé par le fait que dans la chambre d'irradiation (1) on règle une pression d'environ 10 Pa jusqu'à quelques 100 Pa.

11. Procédé selon au moins l'une des revendications précédentes 1 à 10, caractérisé par le fait que l'on règle une fréquence de lignes des faisceaux électroniques (15) sur plusieurs kHz et une fréquence d'image sur environ quelques 10 Hz jusqu'à quelques 100 Hz.

12. Dispositif pour le traitement de vrac constitué de matériau en forme de particules, en particulier de semences, par des faisceaux électroniques dans une chambre d'irradiation disposée verticalement qui présente une ouverture d'entrée supérieure et une ouverture de sortie inférieure pour le vrac et sur laquelle sont radialement disposés plusieurs générateurs de faisceaux électroniques, caractérisé par le fait que la chambre d'irradiation (1) est mise sous vide et qu'elle est munie, à son extrémité supérieure, d'un dispositif de distribution (8, 9) pour dissocier le matériau en forme de particules et par le fait que les générateurs (12) de faisceaux électroniques sont munis de dispositifs de déviation pour élargir en éventail les faisceaux électroniques (15), pour former un champ d'irradiation (11) à travers lequel est guidé, en chute libre, le matériau en forme de particules (2) sortant des dispositifs de distribution (8, 9).

13. Dispositif selon la revendication 12, caractérisé par une chambre d'irradiation (1) avec des canons à électrons (12) disposés sur cette chambre et, chaque fois, un système d'écluses (3, 4) à étages de pression pour écluser le vrac (2) à l'entrée et à la sortie, avec des pompes à vide disposées entre celles-ci, étant précisé que les étages de pression sont composés de plusieurs écluses (5, 6) à roue cellulaire et qu'à une position d'entrée du vrac (2) dans la chambre d'irradiation (1) est disposé un dispositif de distribution (8) pour dissocier celui-ci sur sensiblement toute la section de la chambre d'irradiation (1), que la chambre d'irradiation (1) présente, à la suite du dispositif de distribution (8), un puits de chute (10) pour le vrac (2), que dans la zone de la chute libre du vrac à l'intérieur de la chambre d'irradiation (1) sont disposés, avec celle-ci, au moins deux canons à électrons (12) avec dispositif de déviation pour élargir en éventail le faisceau électronique (15) dans le sens radial par rapport au flux de vrac, que les canons à électrons (12) présentent chacun plusieurs diaphragmes (14) d'un diamètre d'ouverture adapté au faisceau électronique (15), qu'entre un diaphragme (14.2) situé au plus près du côté sortie du faisceau et un diaphragme voisin (14.1) est rapporté un raccord (16) pour l'entrée de l'air dans la chambre d'irradiation (1) par l'intermédiaire d'une vanne (17) et qu'entre les autres diaphragmes (14) des canons à électrons (12) sont chaque fois disposés des générateurs de vide (18).

14. Dispositif selon la revendication 12 ou 13, caractérisé par le fait que le dispositif de distribution (8) présente des tôles de guidage (9) en éventail.

15. Dispositif selon au moins l'une des revendications 12 à 14, caractérisé par le fait que deux canons à électrons (12) sont disposés le long de la chambre d'irradiation (1), diamétralement en face l'un de l'autre et au même niveau et que la chambre d'irradiation (1) présente une longueur axiale telle que pendant sa chute libre dans le champ d'irradiation (11) le vrac (2) est dissocié.

16. Dispositif selon au moins l'une des revendications précédentes 12 à 15, caractérisé par le fait que dans chacun des canons à électrons (12) sont disposés une pluralité de diaphragmes (14.1, 14.2) dont le diamètre va croissant en direction du côté de la sortie du faisceau du canon à électrons (12).

17. Dispositif selon au moins l'une des revendications précédentes 12 à 16, caractérisé par le fait qu'au moins l'écluse à roue cellulaire (5) exposée, côté entrée, à la pression atmosphérique présente une commande de vitesse de rotation.

18. Dispositif selon la revendication 17, caractérisé par le fait qu'en amont de l'écluse à roue cellulaire (5) est monté un dispositif de dosage pour l'introduction du matériau en forme de particules ou du vrac (2).
